# EUROPEAN PATENT APPLICATION

(11) **EP 2 637 266 A1**
(43) Date of publication of application: **11.09.2013**
(21) Application number: 11849359.2
(22) Date of filing: 10.10.2011
(51) Int. Cl.: H01S 5/14, H01Q 11/00

(54) **EXTERNAL CAVITY LASER AND WAVELENGTH DIVISION MULTIPLEXING PASSIVE OPTICAL NETWORK SYSTEM**

(30) Priority: 14.12.2010 CN 201010588118
(71) Applicant: Huawei Technologies Co., Ltd., Shenzhen, Guangdong 518129 (CN)
(72) Inventor: LIN, Huafeng, Shenzhen Guangdong 518129 (CN); XU, Zhiguang, Shenzhen Guangdong 518129 (CN); PENG, Guikai, Shenzhen Guangdong 518129 (CN)
(74) Representative: Körber, Martin Hans
(86) International application number: PCT/CN2011/080595
(87) International publication number: WO 2012/079412

(57) **Abstract**

The embodiments of the present invention disclose an External Cavity Laser (ECL), relate to the filed of Wave Division Multiplexing-Passive Optical Network (WDM-PON) technology, and effectively solves a problem of unstable output optical power of the ECL caused by polarization dependence. The ECL includes a gain medium, a filter, and a Faraday Rotator Mirror (FRM). The gain medium, the filter and the FRM constitute an oscillation cavity, and light emitted by the gain medium oscillates back and forth in the oscillation cavity.

## Description

This application claims priority to Chinese Patent Application No.201010588118.2, filed with the Chinese Patent Office on December 14, 2010 and entitled "EXTERNAL CAVITY LASER AND SYSTEM FOR WAVE DIVISION MULTIPLEXING-PASSIVE OPTICAL NETWORK ", which is incorporated herein by reference in its entirety.

### FIELD OF THE INVENTION

The present invention relates to the field of optical fiber access technologies, in particular, to an External Cavity Laser (ECL) and a system for Wave Division Multiplexing-Passive Optical Network (WDM-PON).

### BACKGROUND OF THE INVENTION

Currently, in many solutions for an optical fiber access network, a WDM-PON technology is closely concerned owing to its advantages such as larger bandwidth capacity and a communication manner similar to point-to-point manner that ensures information security. However, the cost of the WDM-PON is higher, and a laser is the most important factor affecting the cost of the WDM-PON.

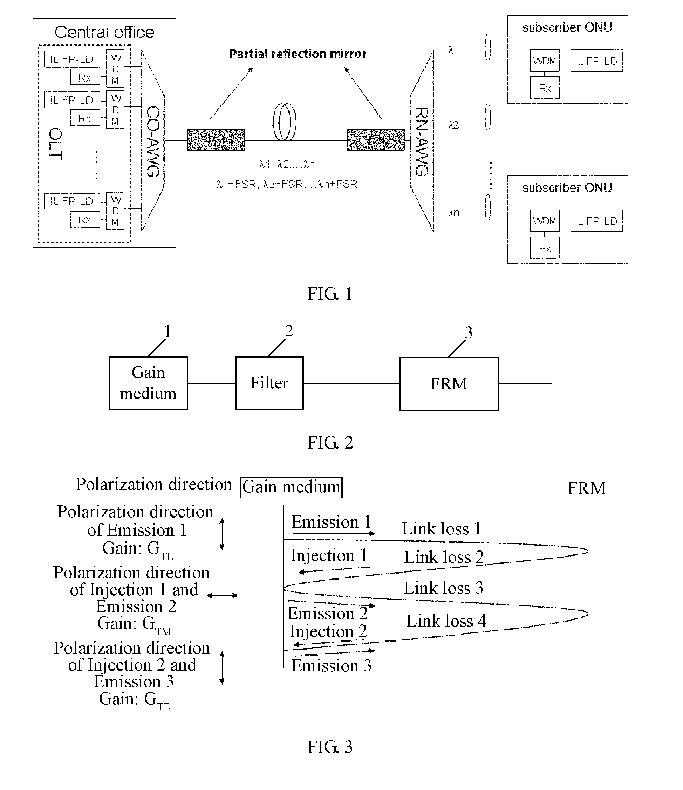

In a WDM-PON system, in order to solve a problem that the cost is high, a solution for a low-cost laser is required to be proposed. FIG. 1 shows a schematic structural diagram of a WDM-PON adopting a self-seeding colorless ECL in the prior art.

Taking a channel whose wavelength is λ1 for example, an optical signal emitted by an injection-locked Fabry-Perot laser diode (IL FP-LD) of an Optical Network Unit (ONU) at a user side is transmitted by a branch optical fiber corresponding to the wavelength λ1, and then passes through a Remote Node Array Waveguide Grating (RN-AWG). Then, through a partial reflection mirror (PRM2), a part of light is transmitted and sent upward to an Optical Line Terminal (OLT) of a Central Office (CO) through a trunk optical fiber, and the other part of the light is reflected back and then passes through the RN-AWG again, and is re-injected back into the IL FP-LD through the branch optical fiber corresponding to the wavelength λ1. A gain cavity of the IL FP-LD re-amplifies the reflected light and then emits the light out. The process repeats many times in this way, so that an optical fiber laser cavity is formed between the IL FP-LD and the PRM2, and a stable optical signal is output. At the same time, the IL FP-LD also has a modulation function, and therefore, uplink data of the ONU may be modulated to the optical signal generated by oscillation, and at least a part of the optical signal is transmitted through the PRM2, a PRM1 and a Central Office Array Waveguide Grating (CO-AWG) to enter a receiver (Rx) corresponding to the wavelength λ1 in the OLT.

In the WDM-PON system, the IL FP-LD is a single polarization multi-longitudinal mode laser, and provides different gains for input light in different polarization directions. The light reflected back by the PRM2 and transmitted through the branch optical fiber has a random polarization direction. Therefore, the IL FP-LD adopted in the conventional WDM-PON system cannot ensure that the reflected light may obtain a stable gain after being injected back into the IL FP-LD, which causes that output optical power of the IL FP-LD is unstable, and tiny swing of the optical fiber caused by any environmental factor, such as temperature, wind, and ground shock, all result in a dramatic change of the output optical power of the IL FP-LD. Therefore, the prior art cannot solve a problem about polarization dependence of the ECL.

### SUMMARY OF THE INVENTION

Embodiments of the present invention provide an ECL and a WDM-PON system, so as to solve a problem of unstable output optical power of a conventional laser caused by polarization dependence.

An ECL includes a gain medium and a filter, and further includes a Faraday rotator mirror (FRM). The gain medium, the filter and the FRM constitute a laser oscillation cavity, and light emitted by the gain medium oscillates back and forth in the oscillation cavity.

A Passive Optical Network (PON) system includes an OLT and multiple ONUs. The OLT communicates with the multiple ONUs in a Wave Division Multiplexing (WDM) manner. The OLT includes an ECL configured to provide a data modulation/transmission function, and the ECL is the preceding ECL.

With the ECL and the WDM-PON system provided in the embodiment of the present invention, the FRM is introduced at a reflection end of the ECL, so that a polarization direction of reflected light injected into the gain medium is controllable, therefore, the problem of unstable output optical power of the conventional ECL caused by polarization dependence is effectively solved.

### BRIEF DESCRIPTION OF THE DRAWINGS

To describe the technical solutions in the embodiments of the present invention or in the prior art more clearly, the accompanying drawings of the prior art or of the embodiments are introduced briefly in the following. Apparently, the accompanying drawings in the following descriptions are merely some embodiments of the present invention, and persons of ordinary skill in the art may also obtain other drawings according to these accompanying drawings without creative efforts.

FIG. 1 is a diagram of a WDM-PON adopting a self-seeding colorless ECL in the prior art;

FIG. 2 is a structural diagram of an ECL according to an embodiment of the present invention;

FIG. 3 is a working principle diagram of an ECL according to an embodiment of the present invention;

FIG. 4 is a structural diagram of another ECL according to an embodiment of the present invention;

FIG. 5 is a structural diagram of another ECL according to an embodiment of the present invention;

FIG. 6 is a schematic structural diagram of a WDM-PON system according to an embodiment of the present invention;

FIG. 7 is a schematic structural diagram of another WDM-PON system according to an embodiment of the present invention; and

FIG. 8 is a schematic structural diagram of another WDM-PON system according to an embodiment of the present invention.

### DETAILED DESCRIPTION OF THE EMBODIMENTS

The technical solutions in the embodiments of the present invention are clearly and completely described in the following with reference to the accompanying drawings. Obviously, the embodiments to be described are only a part rather than all of the embodiments of the present invention. Based on the embodiments of the present invention, all other embodiments obtained by persons of ordinary skill in the art without creative efforts shall fall within the protection scope of the present invention.

First, an ECL is provided in an embodiment of the present invention, as shown in FIG. 2, which includes a gain medium 1, a filter 2, an FRM 3, and optical fibers connecting the preceding members. The FRM 3 may be a 45° rotator mirror, and is coupled to an optical fiber between the filter 2 and an output end (not marked) of the ECL, and may rotate a polarization direction of at least a part of optical signals that are incident through the optical fiber through 45×2 degrees and reflect the optical signals back to the optical fiber. Moreover, in a specific embodiment, the FRM 3 may include a Faraday Rotator (FR) and a PRM. The FR is a 45° FR, and may rotate a polarization direction of light through 45 degrees, so that incident light needs to pass through the FR twice in the process that the incident light enters the FRM 3, a part of the incident light is reflected by the PRM inside the FRM 3 to generate reflected light, and the reflected light is emitted out of the FRM 3. Therefore, the polarization direction of the reflected light deviates from the polarization direction of the incident light by 90 degrees, that is, the polarization direction of the reflected light is perpendicular to the polarization direction of the incident light. The gain medium 1, the filter 2, and the FRM 3 constitute a laser oscillation cavity through the optical fibers. The filter 2 carries out a wavelength (mode) selection function in the laser oscillation cavity, and light emitted by the gain medium 1 oscillates back and forth in the oscillation cavity to form laser light.

During application, the light emitted by the gain medium 1 oscillates back and forth in the laser oscillation cavity to form a self-injection ECL. To facilitate the description, a Transverse Magnetic (TM) mode gain of the gain medium 1 is marked as G_{TM}, a Transverse Electric (TE) mode gain of the gain medium 1 is marked as G_{TE}, and loss of a single link from the gain medium 1 to the 45° FRM is marked as L, where the single link loss L includes coupling loss between the gain medium 1 and the optical fiber, optical loss caused by the filter 2, optical fiber transmission loss, and optical loss caused by the FR and the PRM in the FRM 3.

As shown in FIG. 3, functions and principles of the ECL in this embodiment may be as follows:

First, the gain medium 1 emits an Amplified Spontaneous Emission (ASE) optical signal, and a polarization direction of the ASE optical signal is identical to a TE direction of the gain medium 1, for example, a polarization direction of Emission 1 (that is, first emission light) as shown in FIG. 3. After the optical signal is filtered by the filter 2, only light matching a passband of the filter 2 can pass through the filter 2, and other light out of the passband is attenuated. The optical signal passing through the filter 2 is further transmitted to the FRM 3 through the optical fiber. A part of light is output through a reflection mirror of the FRM 3, and the other part of light is reflected back by the reflection mirror of the FRM 3, and passes through the 45° FR back and forth before and after the refection. The reflected light is re-injected back into the gain medium 1. In this process, the optical signal undergoes link transmission loss twice, and the total loss is 2L.

In this embodiment, the FRM 3 is a 45° FRM, which may rotate a polarization direction of the optical signal through 45 degrees twice by using the 45° FR inside the FRM 3 before and after reflecting the optical signal, so that a polarization direction of the reflected light is perpendicular to a polarization direction of the incident light. According to a reflection characteristic of the 45° FRM, when the reflected light returns to the gain medium 1, the polarization direction of the reflected light is perpendicular to the polarization direction of the first emission light in step a, and therefore, when the reflected light is injected back into the gain medium 1, the polarization direction of the reflected light is identical to a TM mode direction of the gain medium 1, for example, a polarization direction of Injection 1 (that is, first injection light) as shown in FIG. 3. Moreover, correspondingly, a gain obtained by the first injection light inside the gain medium 1 is G_{TM}. After being injected into the gain medium 1, the first injection light is amplified by a gain of G_{TM} to reach a rear end surface of the gain medium 1, and is reflected back by the rear end surface of the gain medium 1, and then is emitted out after being amplified again, so as to form second emission light (that is, Emission 2 in FIG. 3). It should be noted that, in this process, the polarization direction of the reflected light remains constant inside the gain medium 1, and therefore, a polarization direction of the second emission light is consistent with the polarization direction of the first injection light. In addition, in the process that the first injection light goes back and forth inside the gain medium 1, the first injection light obtains a gain in the TM direction twice, and therefore, the total gain is 2 G_{TM}.

Furthermore, after the second emission light is transmitted back and forth in the oscillation cavity (link transmission loss is also 2L), a part of the light is reflected back by the FRM 3, and is re-injected back into the gain medium 1 to form second injection light, that is, Injection 2 as shown in FIG. 3. Likewise, it can be known that a polarization direction of the second injection light is perpendicular to the polarization direction of the second emission light, and therefore, the polarization direction of the second injection light is restored to be the same as the polarization direction of the first emission light, that is, to be the same as the TE mode direction of the gain medium 1. Therefore, a gain obtained by the second injection light inside the gain medium 1 is G_{TE}. In addition, the polarization direction of the second injection light remains constant in the gain medium 1, and after the second injection light undergoes twice TE amplification by passing through the gain medium 1 twice, third emission light is formed and emitted out, that is, Emission 3 as shown in FIG. 3. A polarization direction of the third emission light is completely consistent with that of the Emission 1. In this process, the second injection light goes back and forth inside the gain medium 1, and obtains the gain in the TE direction twice, and therefore, the total obtained gain is 2 G_{TM}.

It can be seen from the preceding working process of the ECL that from the gain medium 1 emitting the first emission light to the gain medium 1 emitting the third emission light, after the light goes back and forth in the oscillation cavity, the polarization direction of the third emission light is adjusted to be consistent with the polarization direction of the first emission light, and therefore, the preceding process may be considered as a complete oscillation that has been accomplished. In the complete oscillation process, the total loss is 4L, and the total gain obtained inside the gain medium is 2 G_{TM} + 2 G_{TE}. According to a working principle of the gain medium, if (2 GTM + 2 GTE) > 4L, after multiple complete oscillations, the light is enhanced continuously, and when the light is enhanced to a certain extent, a gain of the gain medium is saturated, and finally achieves a balanced stable working state. At this time, the output end outputs stable optical power.

A working wavelength of the ECL according to this embodiment is mainly determined by the filter 2, rather than by the gain medium 1. Definitely, a cavity mode of the gain medium and a cavity mode between the gain medium and the FRM 3 also affect a final output wavelength of the ECL, but the effect is generally small. In other words, the gain medium 1 in the ECL in this embodiment is mainly configured to perform a gain function, and the wavelength mainly depends on the filter 2. Therefore, a working wavelength of the gain medium 1 may automatically adapt to a passband wavelength of the filter in the oscillation cavity, without requiring any wavelength calibration and stabilization mechanism, so that the ECL is simple and practical, and is easy to be implemented, and furthermore, the cost is lower.

It should be understood that, in the ECL provided in this embodiment of the present invention, the FRM 3 is not limited to be a 45° FRM 3, and any FRM is acceptable as long as the FRM ensures that the polarization direction of the injection light that returns to the gain medium 1 after several times of reflection is consistent with a polarization direction of original emission light of the gain medium 1. For example, in other alternative embodiments, the FRM 3 may also be a 22.5° rotator mirror, which may enable a polarization direction of an injection light that is generated after four times of reflection to be consistent with the polarization direction of the original emission light. Alternatively, the FRM 3 may also be a rotator mirror having other polarization rotation angles.

Because the ECL provided in this embodiment adopts the FRM 3, the polarization direction of the reflected light injected into the gain medium 1 is controllable, thus ensuring that the polarization direction of the injection light injected into the gain medium is consistent with that of the emission light, so that the problem of unstable output optical power of the conventional ECL caused by polarization dependence is effectively solved.

As an improvement of this embodiment, in addition that the gain medium 1, the filter 2, and the FRM 3 may be connected (coupled) through optical fibers, the gain medium 1, the filter 2, and the FRM 3 may also be connected (coupled) in other manners. For example, in an alternative embodiment, the gain medium 1 and the filter 2 may be coupled through spatial coupling or planar waveguide coupling, and then the filter 2 and the FRM 3 are coupled through an optical fiber.

The ECL provided in this embodiment of the present invention introduces the FRM, so that introducing an optical fiber in the oscillation cavity of the ECL becomes possible, which may greatly facilitate the installation and deployment of the project, and reduce the cost of the ECL. Therefore, implementing the ECL in this embodiment by applying the optical fiber is a preferred implementation manner.

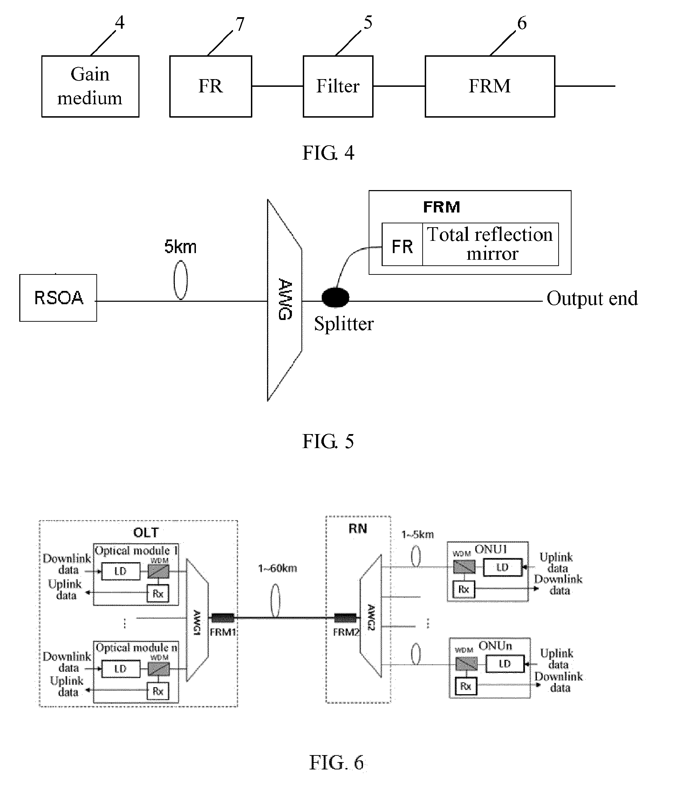

Furthermore, another embodiment of the present invention further provides another ECL, as shown in FIG. 4. The ECL includes a gain medium 4, an FR 7, a filter 5, and a FRM 6. The gain medium 4, the FR 7, the filter 5, and the FRM 6 constitute an oscillation cavity, and light emitted by the gain medium 4 oscillates back and forth in the oscillation cavity.

In an embodiment, the FR 7 may be a 45° FR, and the FRM 6 may be a 45° rotator mirror. The FR 7 is coupled between the gain medium 4 and the filter 5, and the FRM 6 is coupled between the filter 5 and an output end of the ECL. The FR 7 and the FRM 6 may constitute a device that is configured to stabilize a polarization direction of laser in the oscillation cavity, so as to ensure that after emission light emitted by the gain medium 4 undergoes back and forth once, a polarization direction of reflected light can be the same as that of the emission light, and the reflected light is injected back into the gain medium 4. For example, in this embodiment, the FR 7 may perform 45 degrees polarization rotation twice on an optical signal transmitted back and forth, so that rotation of a polarization direction of light during being transmitted in the oscillation cavity exactly offsets 90 degrees rotation generated by the FRM 6, and therefore, after injection light undergoes back and forth once, a polarization direction of the injection light injected into the gain medium 4 is the same as a polarization direction of original emission light.

In a specific embodiment, the FR 7 may be disposed on one side close to the gain medium 4, and perform optical coupling with the gain medium 4 through spatial coupling or planar waveguide coupling. Moreover, the FR 7 may be coupled with the filter 5 and the FRM 6 through optical fibers, or may be coupled in other manners.

For a better understanding of this embodiment, a working process of the ECL is further introduced in the following.

Specifically, after emission light (for example, ASE) emitted by the gain medium 4 passes through the FR 7, a polarization direction of the emission light is rotated through 45 degrees, and the emission light is transmitted to the FRM 6 after being filtered by the filter 5. According to an optical characteristic of the FRM 6, a part of incident light entering the FRM 6 passes through the FRM 6 and is output, the other part of the incident light is reflected by the FRM 6, and the light undergoes 45 degrees polarization back and forth before and after the reflection, so that a polarization direction of the reflected light deviates from a polarization direction of the incident light by 90 degrees, and deviates from the polarization direction of the emission light of the gain medium 4 by 45 degrees or 135 degrees (depending on whether rotation directions of the FR 7 and the FRM 6 are the same). The reflected light returns to the FR 7 through the filter 5, and the polarization direction of the reflected light is further rotated through 45 degrees; and the reflected light is re-injected into the gain medium 4, thus ensuring that the polarization direction of the reflected light is consistent with the polarization direction of the emission light emitted by the gain medium 4.

Therefore, after the emission light emitted by the gain medium 4 is processed by the FR 7, the filter 5, and the FRM 6, the reflected light is re-injected back into the gain medium 4. In the process that the emission light is emitted by the gain medium 4 and finally injected back into the gain medium 4, the polarization direction of the emission light is rotated through 45 degrees four times (including twice 45 degrees polarization rotation performed by the FR 7 and twice 45 degrees polarization rotation performed by the FRM 6), and therefore, the polarization direction of the light is rotated through 0 degree or 180 degrees (depending on whether the rotation directions of the FR 7 and the FRM 6 are the same). Therefore, the polarization direction of the emission light emitted by the gain medium 4 is the same as the polarization direction of the injection light injected back into the gain medium 4 after undergoing back and forth once. That is to say, the polarization direction of the injection light returns to the polarization direction of the original emission light.

In this embodiment, with the FR 7 and the FRM 6, after the emission light emitted by the gain medium 4 of the ECL is reflected once, the polarization direction of the injection light reflected back and injected back into the gain medium 4 may return to the polarization direction of the original emission light, so that loss of the light during the transmission in the oscillation cavity is reduced, and the gain requirement for the gain medium 4 is effectively reduced. Therefore, the ECL provided in this embodiment may have better performance.

In addition, in the preceding embodiments, the filter 2 or 5 may be constituted by one or more filters having a wavelength selection function. As an implementation manner, the filter 2 or 5 may be an AWG, a Gaussian AWG, a thin-film optical filter, or a Gaussian thin-film optical filter. In other implementation manners, the filter 2 or 5 may also be a combined filter formed by a Gaussian AWG and an Etalon filter, a combined filter formed by a Gaussian AWG and an optical fiber grating, or a combined filter formed by other similar optical filters.

As an implementation manner of this embodiment, the gain medium 1 or 4 may include a front end surface and a rear end surface, where the front end surface may be a low-reflective end surface, and the rear end surface may be a high-reflective end surface. Moreover, the front end surface of the gain medium achieves a rather low reflectivity through coating or other technical manners such as an oblique waveguide, and the rear end surface has an extremely high reflectivity. As an implementation manner of this embodiment, the gain medium may be polarization-dependent, that is, a gain of the gain medium in a TE direction is not consistent with a gain of the gain medium in a TM direction, which is advantageous to avoiding polarization mode competition. If the gain medium has polarization dependence, that is, G_{TE} is much larger than G_{TM}, a polarization mode in the TE direction suppresses a polarization mode in the TM direction to be dominant, thus solving a problem of polarization mode competition, and realizing stabilization of the polarization mode in a laser cavity.

As an implementation manner of this embodiment, the gain medium is a Reflective Semiconductor Optical Amplifier (RSOA) having a modulation function, that is, for an electric signal corresponding to data, intensity of an injection current of the gain medium may be changed to modulate the data into an optical signal that is generated by oscillation.

Referring to FIG. 5, in an ECL provided in another embodiment of the present invention, an FRM may be a 45° total reflection FRM, which includes a 45° FR and a total reflection mirror. Moreover, the FRM may be coupled to an optical fiber between a filter (AWG) and an output end of the ECL through a splitter. The splitter may extract a part of emission light passing through the filter from the optical fiber, and provide the light to the FRM. Furthermore, the FRM may perform 45 degrees polarization rotation back and forth on this part of emission light before and after reflection, and reflects reflected light back to the gain medium (RSOA).

Based on the ECL provided in the preceding embodiments, an embodiment of the present invention further provides a WDM-PON system, as shown in FIG. 6. FIG. 6 is a schematic structural diagram of the WDM-PON system according to this embodiment of the present invention. The WDM-PON system includes at least two ECLs configured to provide a data modulation/transmission function, and a specific structure and a working process of the ECL may be referred to the preceding embodiments, that is, all contents of the ECL provided in the preceding embodiments may be incorporated in the WDM-PON system provided in this embodiment by reference.

Specifically, referring to FIG. 6, the WDM-PON system includes an OLT of a CO, multiple ONUs (ONU1-ONUn) at a user side, and an RN located between the OLT and the ONUs and configured to perform wave division multiplexing/demultiplexing (WDM/WDD). The OLT communicates with the multiple ONUs in a WDM manner. The OLT is connected to the RN through a trunk optical fiber, and the RN is further connected to the multiple ONUs respectively through multiple branch optical fibers.

The RN includes a WDM/WDD module, for example, an AWG2. A port at a network side of the AWG2 is connected to the trunk optical fiber, and is configured to receive a downlink optical signal from the OLT. Furthermore, the AWG2 further includes multiple ports at a user side, and each port at the user side is respectively corresponding to a wavelength passband (that is, each port at the user side may be equivalent to a filter, and each filter has a different passband), and is respectively connected, through a branch optical fiber, to an ONU that works at a wavelength channel corresponding to the wavelength passband. The AWG2 may be configured to perform WDD processing on the downlink signal from the OLT, and send the signal to the corresponding ONU respectively through each port at the network side and the branch optical fibers. Moreover, the AWG may further be configured to perform WDM processing on an uplink optical signal from each ONU, and send the signal to the OLT through the port at the user side and the trunk optical fiber.

The ONU may include a light diode (LD) and a light receiver (Rx), and the light emitter and the light receiver are coupled to the branch optical fiber through a wave division multiplexer (WDM). The WDM provides the downlink optical signal transmitted by the branch optical fiber to the light receiver, so as to provide the user with corresponding downlink data, and provides the uplink optical signal that is corresponding to uplink data of the user and emitted by the light emitter for the branch optical fiber, so that the uplink optical signal is further sent upward to the OLT through the RN and the trunk optical fiber. The light emitter may be an RSOA having a modulation function, and may have a gain medium as described in each embodiment of the ECL. A specific characteristic of the gain medium may be made reference to introduction of the preceding embodiments, and is not repeated here.

Moreover, in this embodiment, the RN may further include an FRM (FRM2), and the FRM2 is coupled to a transmission channel of the uplink optical signal, for example, may be directly coupled to the trunk optical fiber close to the port at the network side of the AWG2, or is coupled to the trunk optical fiber of the port at the network side of the AWG2 through a splitter. The gain medium inside the light emitter of the ONU, the AWG2, and the FRM2 may form an ECL as described in the preceding embodiments. A working wavelength of the ECL can automatically adapt to a wavelength of the port of the corresponding AWG2. Through the ECL, the WDM-PON system provided in this embodiment of the present invention may ensure that a polarization direction of injection light injected into the gain medium by using a self-injection laser in an uplink direction is controllable, thus enabling uplink output optical power to remain stable.

In addition, the OLT has a similar structure. For example, the OLT may have multiple optical modules, and each optical module is corresponding to an ONU respectively and works at the same wavelength channel as that of the ONU. The multiple optical modules are coupled to the trunk optical fiber through an AWG1 in the same way, and the AWG1 may perform WDD processing on an uplink optical signal transmitted by the trunk optical fiber and provide the uplink optical signal for a corresponding optical module respectively, and may also perform WDM processing on a downlink optical signal emitted by each optical module and provide the downlink optical signal to each ONU through the trunk optical fiber.

In the OLT, a light emitter of each optical module also has a gain medium as described in the preceding, and the OLT further includes an FRM1 coupled to the trunk optical fiber. The gain medium in the light emitter of the optical module, the AWG1, and the FRM1 may also form an ECL as described in the preceding embodiments. A working wavelength of the ECL can also automatically adapt to a wavelength of the port of the corresponding AWG1. In the same way, through the ECL, the WDM-PON system provided in this embodiment of the present invention may ensure that a polarization direction of injection light injected into the gain medium by using a self-injection laser in a downlink direction is controllable, thus enabling downlink output optical power to remain stable.

In order to realize bi-directional data communication over a single fiber, the AWG1 and the AWG2 may have a cyclic characteristic, so that optical signals of different wave bands may pass through the same port. At the same time, the FRM1 can reflect only an optical signal of a specific waveband, and optical signals of wavebands that cannot be reflected by the FRM1 may pass without being reflected. The FRM2 can also reflect only an optical signal of a specific waveband, and optical signals of wavebands that cannot be reflected by the FRM2 may pass without being reflected.

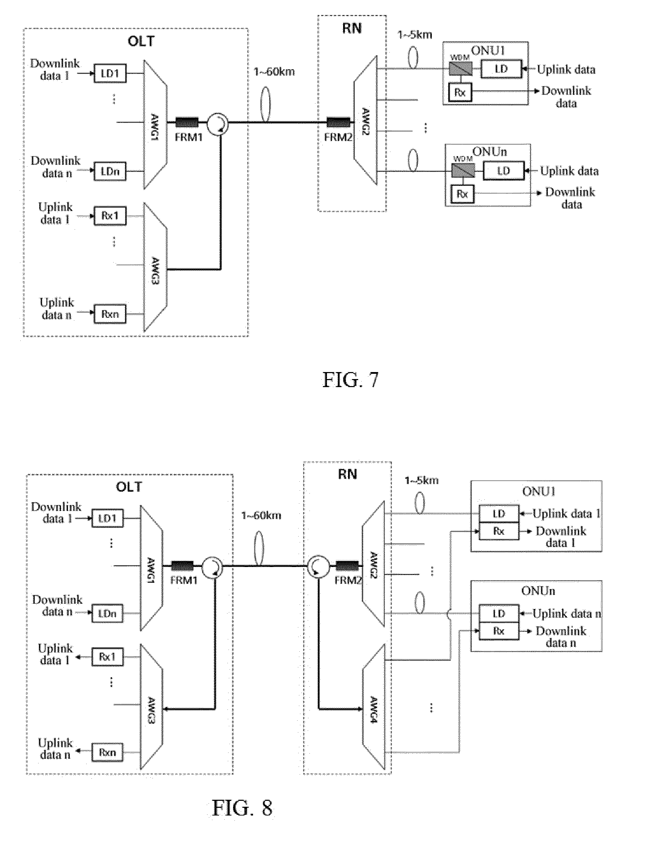

As an improvement of this embodiment, referring to FIG. 7, a schematic structural diagram of another WDM-PON system according to an embodiment of the present invention is shown.

As shown in FIG. 7, an OLT of a CO includes two AWGs, namely, AWG1 and AWG3. The AWG1 is configured to multiplex downlink data transmitted by each light emitter (LD1-LDn), and the AWG3 is configured to demultiplex an uplink optical signal from each ONU (ONU1-ONUn) and transmit the uplink optical signal to each light receiver Rx1-Rxn. In a specific embodiment, the AWG3 is coupled to a trunk optical fiber through a circulator, and an FRM1 of the OLT is disposed between the circulator and the AWG1. The FRM1, the AWG1, and a gain medium in the light diode LD1-LDn form an ECL as described in the preceding embodiments. Moreover, a working wavelength of the ECL can also automatically adapt to a wavelength of the port of the corresponding AWG1.

As a further improvement of this embodiment, referring to FIG. 8, a schematic structural diagram of another WDM-PON system according to an embodiment of the present invention is shown. A structure of an OLT of a CO of the WDM-PON system shown in FIG. 8 is the same as that of the WDM-PON system shown in FIG. 7, and a main improvement lies in a connection structure of an RN and an ONU at a user side.

As shown in FIG. 8, the RN includes two AWGs, namely, AWG2 and AWG4. The AWG2 is configured to multiplex uplink data transmitted by a light emitter LD of each ONU, and the AWG4 is configured to demultiplex a downlink optical signal from the OLT and transmit the downlink optical signal to a light receiver Rx of each ONU. In a specific embodiment, the AWG4 is coupled to a trunk optical fiber through a circulator, and the RN further includes an FRM2, which is disposed between the circulator and the AWG2. The FRM2, the AWG2, and a gain medium in the light emitter LD of the ONU form an ECL as described in the preceding embodiments. Moreover, a working wavelength of the ECL can also automatically adapt to a wavelength of the port of the corresponding AWG1.

Through the preceding description of the embodiments, persons skilled in the art may clearly understand that the present invention may be implemented by software plus necessary universal hardware, and definitely may also be implemented by hardware, but in most cases, the present invention is preferably implemented through the former method. Based on this understanding, the technical solutions of the present invention or the part that makes contributions to the prior art may be substantially embodied in the form of a software product. The computer software product is stored in a readable storage medium, for example, a floppy disk, hard disk, or optical disk of a computer, and include several instructions used to instruct computer equipment (for example, may be a personal computer, a server, or network equipment) to perform the method according to each embodiment of the present invention.

The preceding descriptions are merely specific embodiments of the present invention, but not intended to limit the protection scope of the present invention. Variations or replacements easily figured out by persons skilled in the art without departing from the technical scope disclosed by the present invention shall all fall within the protection scope of the present invention. Therefore, the protection scope of the present invention shall be subject to the protection scope defined by the appended claims.

## Claims

1. An External Cavity Laser (ECL), comprising a gain medium and a filter, wherein the ECL further comprises a Faraday rotator mirror (FRM), the gain medium, the filter and the FRM constitute a laser oscillation cavity, and light emitted by the gain medium oscillates back and forth in the oscillation cavity.

2. The ECL according to claim 1, wherein when emission light emitted by the gain medium is incident upon the FRM through the filter, at least a part of incident light is reflected back to the gain medium by the FRM and re-injected into the gain medium, the FRM rotates polarization directions of the incident light through a preset angle before and after the reflection respectively, and the preset angle enables a polarization direction of injection light to be the same as a polarization direction of the emission light.

3. The ECL according to claim 1, wherein the FRM is a 45° FRM, and a 45° Faraday Rotator (FR) is further disposed between the gain medium and the filter. The 45° FR is disposed on a side close to the gain medium, and the gain medium communicates with the 45° FR through spatial coupling or planar wave-guide coupling.

4. The ECL according to claim 3, wherein the filter is constituted by at least one filter having a wave selection function.

5. The ECL according to claim 4, wherein the filter is an Array Waveguide Grating (AWG), a Gaussian AWG, or a thin-film optical filter, or a combination of a Gaussian AWG and an Etalon filter, or a combination of a Gaussian AWG and a fiber grating, or a combination of other similar optical filters.

6. The ECL according to any one of claims 1 to 5, wherein the FRM is a 45° FRM having a reflection function at a linear part, or a combination of a splitter and a 45° total reflection FRM.

7. The ECL according to any one of claims 1 to 5, wherein the gain medium is a Reflective Semiconductor Optical Amplifier (RSOA) having a modulation function.

8. The ECL according to any one of claims 1 to 5, wherein the gain medium has polarization dependence.

9. A passive optical network (PON) system, comprising an optical line terminal (OLT) and multiple optical network units (ONUs), wherein the OLT communicates with the multiple ONUs by Wave Division Multiplexing (WDM), the OLT comprises an External Cavity Laser (ECL) configured to provide a data modulation/transmission function, and the ECL is the ECL according to any one of claims 1 to 8.

10. The PON system according to claim 9, further comprising a remote node, wherein the remote node is disposed with a Faraday rotator mirror (FRM) and an array waveguide grating (AWG), a port at a network side of the AWG is connected to the OLT through a trunk optical fiber, ports at a user side of the AWG are connected to the multiple ONUs respectively through branch optical fibers, the ONU comprises an optical emitter having a gain medium, and the gain medium of the optical emitter, the AWG, and the FRM constitute the ECL according to any one of claims 1 to 8.

11. An laser, comprising a gain medium, an Array Waveguide Grating (AWG) and a Faraday rotator mirror (FRM), wherein the gain medium couples with the one of the divisional ports of the AWG, wherein the FRM is coupled with the public ports of the AWG, wherein an optical signal emitted by the gain medium oscillates back and forth in a laser oscillation cavity which is constituted with the gain medium and the FRM, so that an emitted wavelength of the laser is locked at the ported wavelength of the divisional port of the AWG.

12. The laser according to claim 11, wherein the optical signal emitted by the gain medium comprises a first polarization direction, and an polarization direction of an optical signal is the same as the polarization direction of the emission light after the optical signal oscillates 2nback and forth in the laser oscillation cavity.

13. The laser according to claim 12,wherein the optical signal comprises a second polarization direction after the optical signal oscillates 2n+1back and forth in the laser oscillation cavity, wherein the second polarization direction is perpendicular to the first polarization direction.

14. The laser according to claim 12, wherein the FRM is configured to rotates polarization directions of the optical signal through a preset angle before and after the reflection respectively when the optical signal emitted by the gain medium is reflected back to the gain medium so that a polarization direction of the optical signal is the same as the first polarization direction of the optical signal after the optical signal oscillates 2nback and forth in the laser oscillation cavity.

15. The laser according to claim 14, wherein the FRM couples between the output of the laser and the public port of the AWG, wherein the FRM comprises a first Faraday Rotator (FR) and reflector mirror which reflects part of optical signals, wherein the first FR is configured to rotates the first preset angle before and after the reflection is reflected by the reflector mirror which reflects part of optical signals.

16. The laser according to claim 14, wherein the FRM couples the public port of the AWG through a splitter, wherein the FRM comprises a first FR and total reflection FRM, wherein the first FR is configured to rotates a polarization direction of the optical signal is the same as the first polarization direction of the optical signal after the optical signal is reflected by the total reflection FRM.

17. The laser according to claim 11, wherein the laser further comprises a FR, wherein the FR is set inside of the oscillation cavity, and couples between the gain medium and the branch port of the AWG, wherein the optical signal emitted by the gain medium comprises a first polarization direction of the optical signal, wherein the polarization direction of the gain medium is the same as the first polarization direction after the optical signal oscillates back and forth in the laser oscillation cavity.

18. The laser according to claim 17, wherein the FRM is configured to rotate polarization directions of the optical signal through a first preset angle before and after the reflection respectively when the optical signal emitted by the gain medium is reflected back to the gain medium; wherein the FR is configured to rotate polarization direction of the optical signal through a second preset angle before the optical signal emitted by the gain medium is transmitted to the FRM, and rotate again polarization direction of the optical signal through the second preset again after the optical signal is reflected by the FRM and before the optical signal is reflected back to the gain medium.

19. The laser according to claim 18, wherein the first preset angle and the second preset angle are 45 degree.

20. A method for emitting optical signal, comprising:
emitting an optical signal, by a gain medium, wherein the optical signal comprises a first polarization direction of the optical signal;
transmitting, by an Array Waveguide Grating (AWG), the optical signal to a Faraday rotator mirror (FRM) after the AWG perform a wavelength selection through an branch port;
rotating polarization direction of the optical signal through the preset angle before and after the reflection respectively when the optical signal emitted by the gain medium is reflected back to the gain medium so that a polarization direction of the optical signal which is incident back to the gain medium comprises a second polarization direction which is perpendicular to the first polarization direction.
